# EUROPÄISCHE PATENTSCHRIFT

(11) **EP 0 793 735 B1**
(45) Veröffentlichungstag und Bekanntmachung des Hinweises auf die Patenterteilung: **30.06.1999**
(21) Anmeldenummer: 95938448.8
(22) Anmeldetag: 17.11.1995
(51) Int. Cl.: C23C 16/32, C23C 16/56, F16K 25/00

(54) **DICHTUNGSELEMENT, INSBESONDERE FÜR ABSPERR- UND REGELORGANE UND VERFAHREN ZU SEINER HERSTELLUNG**
PACKING ELEMENT, IN PARTICULAR FOR SHUTTING-OFF AND REGULATING MEANS, AND PROCESS FOR PRODUCING THE SAME
ELEMENT D'ETANCHEITE, NOTAMMENT POUR ORGANES D'OBTURATION ET DE REGULATION, ET SON PROCEDE DE FABRICATION

(30) Priorität: 21.11.1994 DE 4441132
(43) Veröffentlichungstag der Anmeldung: 10.09.1997
(73) Patentinhaber: FRIEDRICH GROHE AG, 58653 Hemer (DE)
(72) Erfinder: WAGNER, Friedrich, D-79346 Endingen (DE); STRELOW, Hans-Peter, D-79106 Freiburg (DE)
(74) Vertreter: Pätzold, Herbert, Dr.-Ing.
(86) Internationale Anmeldenummer: EP9504535
(87) Internationale Veröffentlichungsnummer: WO9616201

(56) Entgegenhaltungen:
- WO-A-96/16200
- WO-A-96/16202
- DE-A- 3 832 692
- DE-C- 3 907 857

## Beschreibung

Die Erfindung bezieht sich auf ein Dichtungselement, gemäß dem Oberbegriff des Anspruches 1. Solche Dichtungskörper können aus einem metallischen oder nicht-metallischen Werkstoff bestehen. Bei nichtmetallischen Werkstoffen kann es sich beispielsweise um einen Keramikwerkstoff handeln, wozu Aluminiumoxid Al₂O₃ und die verschiedenen Siliciumcarbide SiC, Si₂C und Siliciumnitrid Si₃N₄ gehören.

Auf der Dichffläche des Absperrkörpers ist im Wege der Plasma-CVD oder Plasmapolymerisation in einer Beschichtungskammer eine Hartstoffschicht aufgetragen, die Kohlenstoff und Silicium enthält.

Die Hartstoffschicht kann im wesentlichen homogen sein. Sie kann aber auch einen lamellenartigen Aufbau besitzen. Vorteilhafterweise kann die Hartstoffschicht einen auf die Arbeitsfläche des Absperrkörpers aufgetragenen Haftschichtanteil und einen anschließenden Deck-bzw Gleitschichtanteil umfassen. Der Haftschichtanteil kann vorteilhafterweise einen die Haftung an der Arbeitsfläche des Absperrkörpers begünstigenden ersten Siliciumanteil, und der anschließende kohlenstoffhaltige Deckschichtanteil kann zur Erzielung niedriger Gleit- und Haftreibungskoeffizienten vorteilhafterweise einen geringeren zweiten Siliciumanteil besitzen als der Haftschichtanteil. Der Haftschichtanteil kann auch siliciumfrei sein.

Die Abscheidung aus dem Plasma erfolgt durch lonenbeschuß, z.B. mittels einer Glimmentladung oder durch eine zusätzliche lonenkanone. Aus einer kohlenwasserstoffhaltigen Atmosphäre kann dabei eine verschleißfeste kohlenstoffhaltige Schicht zur Abscheidung gebracht werden, die ausreichend niedrige Gleit- und Haftreibungskoeffizienten aufweist.

Ein Dichtungselement der vorstehenden Art mit einer Hartstoffschicht, die einen auf die Arbeitsfläche des Absperrkörpers aufgetragenen Haftschichtanteil und einen anschließenden Deckschichtanteil umfaßt und das zugehörige Plasma-CVD-Beschichtungsverfahren zum Auftragen der Hartstoffschicht auf die Arbeitsfläche des Absperrkörpers sind durch die DE-OS 38 32 692 bekannt.

Hiemach werden Absperrkörper zur Beschichtung ihrer Arbeitsflächen auf einem relativ zum Plasma negativ gepolten Probenhalter in der Beschichtungskammer gelegt. Zur anfänglichen physikalischen Ätzung der Arbeitsflächen der Absperrkörper mit Argon wird die Beschichtungsanlage zunächst als Kathodenzerstäubungs(Sputter)-Anlage betrieben. Zur anschließenden Abscheidung des Haftschichtanteils der Hartstoffschicht auf die geätzte Arbeitsfläche wird dieselbe Anlage dann unter bestimmten ersten Prozeßparametem als Hochfrequenz-Plasma-CVD-Anlage betrieben, wobei das Argongas in der Beschichtungskammer, z.B. durch Tetramethylsilan ersetzt wird. Unter geänderten zweiten Prozeßparametern wird anschließend nach der Abscheidung des Haftschichtanteils der Deck- bzw. Gleitschichtanteil aus einem Gasgemisch aus Tetramethylsilan und Hexan abgeschieden.

Die hiemach erhaltenen Dichtungselemente (es kann sich vorteilhafterweise um beschichtete Keramikscheiben für Wasserarmaturen, z.B. Einhandmischer, handeln) besitzen dank der aufgetragenen Hartstoffschicht auch in Gegenwart von Wasser beim Aufeinandergleiten ausreichend niedrige Gleit- und Haftreibungskoeffizienten, so daß ein Einfetten der Dichtungsflächen nicht länger notwendig ist, wie es bislang bei unbeschichteten Keramikscheiben erforderlich war.

Nachteilig ist bei den bekannten Dichtungselementen, die mit einer ein- und mehrschichtigen Hartstoffschicht beschichtet sind, daß ihre Heißwasserbeständigkeit vielfach unbefriedigend ist. Das gilt insbesondere dann, wenn eine Heißwasserbeständigkeit von mehr als 1000 Betriebsstunden erreicht werden soll, ohne daß die aufgetragene Hartstoffschicht sich vom Absperrkörper ablöst. Die Heißwasserbeständigkeit ist auch dann besonders unbefriedigend, wenn nach der Lehre der DE-OS 38 32 692 die äußere Deckschicht dicker ist als die innere Haftschicht. Ein solches Dickenverhältnis hat sich als völlig unbrauchbar herausgestellt, um das Problem der Heißwasserbeständigkeit zu lösen.

Aufgabe der Erfindung ist es, ein Dichtungselement der eingangs genannten Art anzugeben, das bei ausreichend niedrigen Haft- und Gleitreibungskoeffizienten an der Gleitschichtoberfläche eine hohe Heißwasserbeständigkeit aufweist. Bevorzugte Dichtungselemente, insbesondere in Scheibenform sollen eine Heißwasserbeständigkeit bei 95°C über einen ausreichenden Betriebszeitraum, z.B. von mindestens 1000 Stunden aufweisen, ohne daß vor allem die Haftung der Hartstoffschicht am Absperrkörper wesentlich in Mitleidenschaft gezogen wird.

Die Aufgabe wird erfindungsgemäß mit den kennzeichnenden Merkmalen der Ansprüche 1, 3 und 4 gelöst. Vorteilhafte Ausführungen und Weiterbildungen sowie der Herstellung des Dichtungselementes ergeben sich aus den Merkmalen der Unteransprüche 2 und 5 bis 12.

Durch die DE 3 907 857 C1 ist aus der Halbleitertechnik ein Beschichtungsverfahren zur Beschichtung eines Silicium-Substrates mit einer ultradünnen Silicium-Karbidmembranschicht bekannt, deren Spannung durch lonenbeschuß mit Wasserstoffionen emiedrigt wird, wobei bei gleichzeitiger Temperung bei 450° die Spannung weiter emiedrigt werden kann. Diese Erkenntnisse aus der Halbleitertechnik sind zur Lösung der andersartigen Probleme zur Erhöhung der Heißwasserbeständigkeit von mit Hartstoffschichten versehenen Dichtungselementen, beispielsweise für Wasserarmaturen, nicht vergleichbar.

Es war erfinderseits überraschend, daß durch ein Tempem der fertig beschichteten Absperrkörper ihre Heißwasserbeständigkeit wesentlich erhöht werden kann. Es war nicht voraussehbar, daß durch ein gezieltes Tempem der beschichteten Absperrkörper insbesondere eine Haftverstärkung der aufgetragenen Hartstoffschicht an dem Absperrkörper erreicht werden kann, wobei erstaunlich gute reproduzierbare Ergebnisse erzielt werden konnten, was für eine Fertigung der Dichtungselemente mit der angestrebten hohen Qualität in hoher Stückzahl im industriellen Maßstab von besonderer Wichtigkeit ist.

Besonders gute Ergebnisse werden erfindungsgemäß erreicht, wenn die aufgebrachte Hartstoffschicht einen Haftschichtanteil und einen Deckschichtanteil entsprechend der vorstehend genannten DE-OS 38 32 692 aufweist und dabei der Schichtenaufbau der Hartstoffschicht in einer Weise optimiert ist, daß der Haftschichtanteil der Hartstoffschicht nicht nur ausreichend hohe Haftungseigenschaften an der Arbeitsfläche des Absperrkörpers aufweist, sondem auch die hohen Eigenspannungen des vergleichsweise relativ harten und spröden Gleitschichtanteils der Hartstoffschicht sicher aufzunehmen vermag. Hierzu ist es vorteilhaft, wenn erfindungsgemäß der Gleitschichtanteil weitgehend dünn und der Haftschichtanteil demgegenüber ausreichend dick gewählt ist damit er die Eigenspannungen des Gleitschichtanteiles aufzunehmen vermag.

Dem Haftschichtanteil kommt daher erfindungsgemäß die doppelte Aufgabe zu, einerseits die notwendige Haftung an dem Absperrkörper auch unter extremer Heißwasserbelastung bei 95°C während langer Betriebszeiten von 1000 und mehr Stunden sicher aufrecht zu erhalten und andererseits die Eigenspannungen des Gleitschichtanteiles ohne wesentlichen Verlust an Haftungsstärke auf Dauer aufnehmen zu können. Durch das erfindungsgemäße Tempem lassen sich diese Eigenschaften des Haftschichtanteils überraschenderweise wesentlich verbessem und langzeitig sichem.

Das Tempem eines Absperrkörpers kann nach seiner Beschichtung innerhalb der Beschichtungskammer oder auch außerhalb dieser z.B. in einem Autoklaven oder dergleichen Druckbehälter vorgenommen werden. Das Tempem kann in einer sauerstoffhaltigen Atmosphäre oder auch an der Luft oder in Gegenwart von Luft bei Atmosphärendruck durchgeführt werden. Das Tempem kann bei Temperaturen zwischen 100 bis 1500°C, vorzugsweise zwischen 400 und 1000°C erfolgen, wobei vorzugsweise Temperungszeiten zwischen 0,5 bis 60 min liegen können. Hervorragende Ergebnisse werden bei Temperaturen von 500 und 900°C erreicht.

Die Erfindung wird nachstehend ohne jede Beschränkung anhand eines Ausführungsbeispiels beschrieben. Zur Beschichtung wird eine Beschichtungskammer verwendet, die im wesentlichen der Beschichtungskammer entspricht, wie sie bereits in der DE-OS 38 32 692 gezeigt ist.

Die bekannte Beschichtungskammer besteht im Prinzip aus einem elektrisch leitenden Kammerboden, an dem ein ebenfalls elektrisch leitendes, allseits abgeschlossenes Kammergehäuse angeschlossen ist. Der Kammerboden besitzt einen isolierten Anschluß für eine Durchführung, die eine Verbindung zwischen der als Kathodenauflage dienenden Kathode und einer elektrischen Versorgung in der Gestalt einer Hochfrequenzeinrichtung herstellt. Auf die Kathodenauflage werden die Absperrkörper mit der zu beschichtenden Fläche nach oben gelegt. Im vorliegenden Fall handelt es sich, ohne Einschränkung, um Al₂O₃-Keramikscheiben für Hydraulikarmaturen, wobei die Keramikscheiben mit einer Hartstoffschicht beschichtet sind, im Sinne der DE-OS 38 32 692 aus einem Haftschichtanteil und einem anschließenden Deckschichtanteil besteht.

Der Kammerboden besitzt außerdem einen zweiten Anschluss für ein Absaugrohr, das an eine Vakuumpumpstation angeschlossen ist. Schließlich besitzt der Kammerboden Anschlüsse für die Zuleitung von Prozeßgasen in die Beschichtungskammer.

Zur Durchführung einer Beschichtung wird zunächst die Vakuumpumpstation eingeschaltet und in der Beschichtungskammer wird ein Druck von etwa 8 x 10⁻⁵ mbar eingestellt. Anschließend wird über ein Gaszuleitungsrohr Argon in die Beschichtungskammer eingeleitet bis ein Gasdruck von etwa 6 µbar erreicht ist. Sodann wird die Hochfrequenzeinrichtung eingeschaltet und die Glimmentladung gezündet. Dabei wird eine Kathoden-gleichspannung von etwa 600 bis 800 V eingestellt. Hierbei arbeitet die Beschichtungsanlage zunächst als Kathodenzerstäubungs-(Sputter)anlage, in der die Kathodenauflage und die auf ihr liegenden Keramikscheiben durch lonenbeschuß physikalisch geätzt werden. Die Ätzdauer beträgt etwa 15 bis 25 min, vorzugsweise 20 min.

Bereits etwas vor dem Ende der Ätzperiode wird der Zufluß von Argon in die Kammer stufenweise gedrosselt und gleichzeitig Tetramethylsilan (TMS) der Kammer stufenweise in zunehmendem Maße zugeführt, um dadurch einen möglichst weichen Übergang zum Haftschichtanteil der Hartstoffschicht zu erhalten. Bei einer verringerten Kathodenspannung von etwa 500 bis 600 V wird der Haftschichtanteil der Hartstoffschicht etwa 15 bis 30 min lang bis zu einer Stärke von etwa 1 µm auf den mit Argon geätzten Flächen zur Abscheidung gebracht. Hierbei handelt es sich um vor allem eine amorphe siliciumhaltige Kohlenstoff-/Wasserstoffschicht. Anschließend wird der Gleitschichtanteil auf den Haftschichtanteil zur Abscheidung gebracht, wobei im Beispielsfalle in der Beschichtungskammer ein Gasgemisch aus TMS und Hexan im Verhältnis von etwa 1:1.5 bis etwa 1:8, vorzugsweise etwa 1:2 bis 1:5 eingestellt wird. Hervorragende Ergebnisse werden mit einem Mischungsverhältnis 1:2 erzielt.

Um auch einen weichen Übergang vom Haftschichtanteil zum Gleitschichtanteil zu erhalten, wird die TMS-Zufuhr während einer Übergangszeit stufenweise gedrosselt, und entsprechend wird stufenweise die Zufuhr von Hexan gesteigert, bis das gewählte TMS/Hexangemisch erreicht ist. Zwischen den einzelnen Umschaltschritten von Stufe zu Stufe liegen jeweils etwa 3 s. Die Beschichtungszeit für den Gleitschichtanteil beträgt in Abhängigkeit von der gewählten Schichtdicke des Gleitschichtanteil von 0,4 µm bis 0,9 µm etwa 10 bis 20 min. Der Siliciumgehalt im Gleitschichtanteil ist deutlich geringer als im Haftschichtanteil. Entsprechend ist dafür der Kohlenstoffgehalt im Gleitschichtanteil deutlich höher als im Haftschichtanteil. Die Dicke des Gleitschichtanteils ist erfindungsgemäß vorteilhafterweise dünner gewählt als die Dicke des Haftschichtanteils, damit der Haftschichtanteil die relativ hohe Eigenspannung des Gleitschichtanteils ohne wesentliche Beeinträchtigung seiner Haftung an der Arbeitsfläche des Absperrkörpers aufzunehmen vermag. Das Dickenverhältnis von Haftschichtanteil zu Gleitschichtsanteil beträgt etwa 1:0,9 bis 1:0,4, vorzugsweise 1:0,6.

Erfindungsgemäß werden die auf vorstehende Weise beschichteten Absperrkörper (im Beispielsfalle handelt es sich um Keramikscheiben aus Al₂O₃) einer gezielten Wärmebehandlung unterzogen. Die Erfindung ist jedoch nicht auf derartige Absperrkörper beschränkt, was sowohl die Gestalt der Absperrkörper betrifft als auch die auf sie aufgebrachte Hartstoffschicht. So kann es sich auch um homogene oder um lamellierte Hartstoffschichten handeln. Es kann sich auch um eine Hartstoffschicht handeln, bei der eine Haftschicht nach der DE-OS 38 32 692 nicht erforderlich ist und die Deckschicht mit ausreichendem Haftungsvermögen unmittelbar auf dem Absperrkörper, z.B. aus Si₃N₄ aufgebracht werden kann.

### BEISPIEL

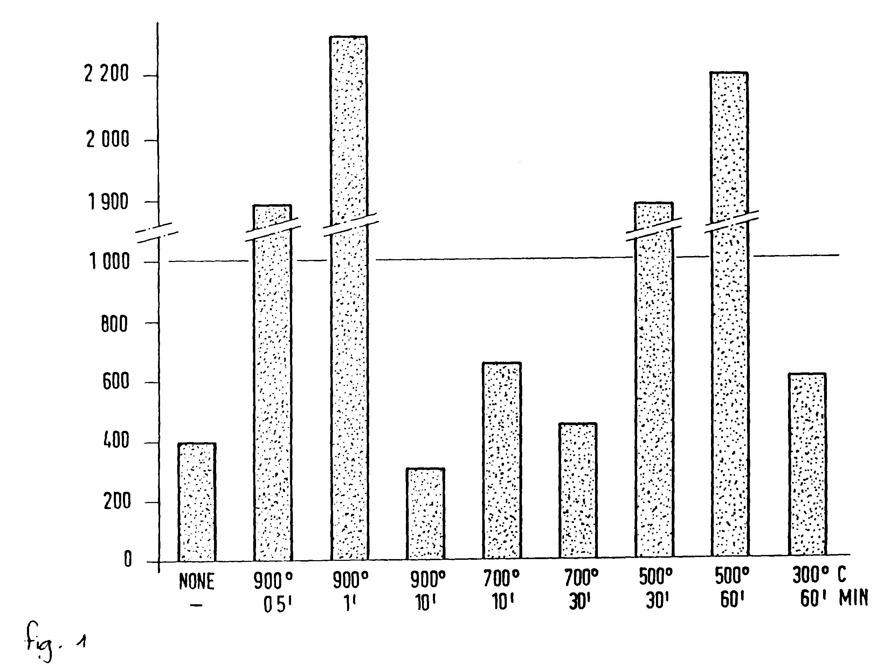

Die Beschichtungscharge C 3099 für Keramikscheiben, bei der der Gleitschichtanteil bei einem Mischungsverhältnis von TMS: Hexan von etwa 1:2 hergestellt wurde und das Dickenverhältnis von Haftschichtanteil zu Gleitschichtanteil etwa 1 µm : 0,6 µm beträgt, wurde einer Wärmenachbehandlung zwischen 300 und 900°C während 0,5 bis 60 min. ausgesetzt. Das Ergebnis ist in einem Blockdiagramm in der beigefügten Zeichnung im Vergleich zu einer unbehandelten Scheibe dargestellt. Auf der Ordinate sind die Betriebszeiten der Keramikscheiben in einer Armatur bei einer Heißwasserbelastung von 95°C angegeben. Ohne Wärmenachbehandlung weisen die Keramikscheiben eine Heißwasserbeständigkeit bei 95°C von etwa 400 h auf.

Hervorragende Ergebnisse wurden bei einer Wärmenachbehandlung bei 900°C während 0,5 und 1 min und bei einer Wärmenachbehandlung vom 500°C während 30 und 60 min erzielt. Spitzenergebnisse wurden bei 900°C während 1 min. und bei 500°C während 1 h mit einer Heißwasserbeständigkeit von jeweils über 2200 h erreicht.

## Patentansprüche

1. Dichtungselement, insbesondere für Absperr- und Regelorgane, bestehend aus einem plattenförmigen, kolbenförmigen oder kugelförmigen Absperrkörper aus einem metallischen oder nicht-metallischen Werkstoff, beispielsweise Keramikwerkstoff, mit einer auf der als Dichtfläche ausgebildeten Arbeitsfläche des Absperrkörpers im Wege der Plasma-CVD oder Plasmapolymerisation im um-Bereich aufgetragenen Hartstoffschicht, die Kohlenstoff und Silicium enthält und die aus einem an die Arbeitsfläche des Absperrkörpers angrenzenden inneren Haftschichtanteil und einem anschließenden als Gleitschicht ausgebildeten äußeren Deckschichtanteil besteht und wobei der kohlenstoffhaltige Haftschichtanteil einen ersten Siliciumanteil und der kohlenstoffhaltige Deckschichtanteil einen geringeren zweiten Siliciumanteil als der Haftschichtanteil aufweist oder siliciumfrei ist,
**dadurch gekennzeichnet,**
daß die aus einem dünnen Deckschichtanteil und einem vergleichsweise dicken Haftschichtanteil bestehende Hartstoffschicht getempert ist.

2. Dichtungselement nach Anspruch 1,
**dadurch gekennzeichnet,** daß das Dickenverhältnis von Haftschichtanteil : Gleitschichtanteil etwa 1:0,9 bis 1:0,4, vorzugsweise 1:0,6 beträgt.

3. Verfahren zur Herstellung des Dichtungselementes nach Anspruch 1,
**dadurch gekennzeichnet**, daß der Absperrkörper nach seiner Beschichtung in der Beschichtungskammer getempert wird.

4. Verfahren zur Herstellung des Dichtungselementes nach Anspruch 1,
**dadurch gekennzeichnet**, daß der Absperrkörper außerhalb der Beschichtungskammer getempert wird.

5. Verfahren nach Anspruch 3 oder 4,
**dadurch gekennzeichnet**, daß das Tempern in einer sauerstoffhaltigen Atmosphäre durchgeführt wird.

6. Verfahren nach Anspruch 3 oder 4,
**dadurch gekennzeichnet**, daß das Tempern an der Luft oder in Gegenwart von Luft bei Atmosphärendruck durchgeführt wird.

7. Verfahren nach Anspruch 3 oder 4,
**dadurch gekennzeichnet**, daß das Tempern in einem Wasserbad durchgeführt wird.

8. Verfahren nach Anspruch 3 oder 4,
**dadurch gekennzeichnet,** daß das Tempern in einem Druckbehälter durchgeführt wird.

9. Verfahren nach Anspruch 3 oder 4,
**dadurch gekennzeichnet,** daß die Temperatur der Temperung in Abhängigkeit vom Schichtdickenaufbau und/oder der Zusammensetzung der Hartstoffschicht aus dem Haft- und Deckschichtanteil gewählt ist.

10. Verfahren nach Anspruch 3 oder 4,
**dadurch gekennzeichnet**, daß die Temperung bei etwa 500°C etwa 30 min bis etwa 1 h oder bei etwa 900° etwa 0,5 min bis etwa 1 min beträgt.

11. Verfahren nach Anspruch 3 oder 4,
**dadurch gekennzeichnet,** daß die Temperungszeit abhängig ist von der Beschichtungszeit.

12. Verfahren nach Anspruch 3 oder 4, dadurch gekennzeichnet, daß zur Abscheidung des Haftschichtenanteils Tetramethylsilan und zur Abscheidung des Gleitschichtantels ein Gasgemisch von Tetramethylsilan und Hexan verwendet wird, wobei das Mischungsverhältnis von Tetramethylsilan:Hexan etwa 1:1,5 bis 1:5, vorzugsweise etwa 1:2 beträgt.

## Claims

1. Packing element, in particular for shutting off and regulating means, consisting of a plate-shaped, piston-shaped or spherical shut-off body made of a metallic or non-metallic material, for example a ceramics material, and having a hard material layer applied to the working surface, configured as a sealing surface, of the shut-off body by means of a plasma CVD process or plasma polymerization in the µm range, which layer contains carbon and silicon and consists of an inner adhesive layer portion adjacent to the working surface of the shut-off body and a connecting outer cover layer portion configured as a slide layer, the adhesive layer portion, containing carbon, having a first silicon portion and the cover layer portion, containing carbon, having a smaller second silicon portion than the adhesive layer portion or being silicon-free,
**characterised in that**
the hard material layer consisting of a thin cover layer portion and a comparatively thick adhesive layer portion is annealed.

2. Packing element according to claim 1,
**characterised in that** the thickness ratio of the adhesive layer portion:slide layer portion is roughly 1:0.9 to 1:0.4, preferably 1:0.6.

3. Method of manufacturing the packing element according to claim 1,
**characterised in that** the shut-off body is annealed after being coated in the coating chamber.

4. Method of manufacturing the packing element according to claim 1,
**characterised in that** the shut-off body is annealed outwith the coating chamber.

5. Method according to claim 3 or 4,
**characterised in that** the annealing is carried out in an oxygenous atmosphere.

6. Method according to claim 3 or 4,
**characterised in that** the annealing is carried out in fresh air or in the presence of air at atmospheric pressure.

7. Method according to claim 3 or 4,
**characterised in that** the annealing is carried out in a water bath.

8. Method according to claim 3 or 4,
**characterised in that** the annealing is carried out in a pressure tank.

9. Method according to claim 3 or 4,
**characterised in that** the temperature of the annealing is selected in dependence on the layer thickness structure and/or the composition of the hard material layer from the adhesive layer portion and the cover layer portion.

10. Method according to claim 3 o4,
**characterised in that** the annealing at approximately 500°C lasts roughly 30 min to roughly 1 hour, or at approximately 900° lasts roughly 0.5 min to roughly 1 min.

11. Method according to claim 3 or 4,
**characterised in that** the annealing time depends on the coating time.

12. Method according to claim 3 or 4,
**characterised in that** tetramethylsilane is used to deposit the adhesive layer portion, and a gas mixture of tetramethylsilane and hexane is used to deposit the slide layer, the mixture ratio of tetramethylsilane:hexane being approximately 1:1.5, preferably approximately 1:2.

## Revendications

1. Elément d'étanchéité, notamment pour organes d'obturation et organes de réglage, constitué d'un corps d'obturation en matière métallique ou non métallique, par exemple matière céramique, en forme de plaque, de piston ou de sphère, comprenant une couche de matière dure, contenant du carbone et du silicium, qui est déposée sur la surface de travail, réalisée sous forme d'une surface d'étanchéité, du corps d'obturation au cours du procédé de dépôt en phase vapeur par voie chimique au plasma ou de la polymérisation au plasma dans le domaine des µm, et qui est constituée d'une partie de couche d'adhérence, intérieure, adjacente à la surface de travail du corps d'obturation et d'une partie de couche de recouvrement, adjacente et extérieure, réalisée sous forme de couche de glissement, tandis que la partie de couche d'adhérence contenant du carbone comprend une première proportion de silicium et que la partie de couche de recouvrement contenant du carbone comprend une seconde proportion de silicium plus faible que la partie de couche d'adhérence ou est dépourvue de silicium,
caractérisé
en ce que la couche de matière dure constituée d'une partie de couche de recouvrement mince et d'une partie de couche d'adhérence relativement épaisse est soumise à un recuit.

2. Elément d'étanchéité suivant la revendication 1, caractérisé en ce que le rapport d'épaisseur partie de couche d'adhérence : partie de couche de glissement vaut approximativement 1 : 0,9 à 1 : 0,4, de préférence 1:0,6.

3. Procédé de fabrication de l'élément de la revendication 1, caractérisé en ce que le corps d'obturation est soumis à un recuit dans la chambre de revêtement après son revêtement.

4. Procédé de fabrication de l'élément d'étanchéité de la revendication 1, caractérisé en ce que le corps d'obturation est soumis à un recuit en dehors de la chambre de revêtement.

5. Procédé suivant la revendication 3 ou 4, caractérisé en ce que le recuit est exécuté dans une atmosphère contenant de l'oxygène.

6. Procédé suivant la revendication 3 ou 4, caractérisé en ce que le recuit est exécuté à l'air ou en présence d'air à la pression atmosphérique.

7. Procédé suivant la revendication 3 ou 4, caractérisé en ce que le recuit est exécuté dans un bain d'eau.

8. Procédé suivant la revendication 3 ou 4, caractérisé en ce que le recuit est exécuté dans un récipient sous pression.

9. Procédé suivant la revendication 3 ou 4, caractérisé en ce que la température du recuit est choisie en fonction de la structure d'épaisseurs des couches et/ou de la composition de la couche de matière dure formée de la partie de couche d'adhérence et de la partie de couche de recouvrement.

10. Procédé suivant la revendication 3 ou 4, caractérisé en ce que le recuit dure d'environ 30 minutes à environ 1 heure à approximativement 500 °C ou d'environ 0,5 minute à environ 1 minute à approximativement 900 °C.

11. Procédé suivant la revendication 3 ou 4, caractérisé en ce que la durée de recuit dépend de la durée de revêtement.

12. Procédé suivant la revendication 3 ou 4, caractérisé en ce que, pour le dépôt de la partie de couche d'adhérence, on utilise du tétraméthylsilane et, pour le dépôt de la partie de couche de glissement, un mélange gazeux de tétraméthylsilane et d'hexane, le rapport de mélange valant approximativement 1:1,5 à 1 : 5, de préférence approximativement 1:2.
